(19) Europäisches Patentamt
European Patent Office
Office européen des brevets

(11) Publication number: **0 122 047**
**B1**

(12) # EUROPEAN PATENT SPECIFICATION

(45) Date of publication of patent specification: **01.06.88**

(51) Int. Cl.[4]: **H 01 L 29/16**, H 01 L 29/24, H 01 L 29/04

(21) Application number: **84301599.1**

(22) Date of filing: **09.03.84**

(54) **A multi-layered amorphous semiconductor material.**

(30) Priority: **11.03.83 US 474442**

(43) Date of publication of application:
**17.10.84 Bulletin 84/42**

(45) Publication of the grant of the patent:
**01.06.88 Bulletin 88/22**

(84) Designated Contracting States:
**DE FR GB IT**

(56) References cited:
**GB-A-2 083 705**
**US-A-4 163 237**
**US-A-4 261 771**

**THIN SOLID FILMS, vol. 90, no. 4, April 1982, Lausanne W.E. SPEAR et al. "Recent applied developments in the amorphous silicon field", pages 359-370**

(73) Proprietor: **Exxon Research and Engineering Company**
**P.O.Box 390 180 Park Avenue**
**Florham Park New Jersey 07932 (US)**

(72) Inventor: **Abeles, Benjamin**
**115 Randall Road**
**Princeton New Jersey 08540 (US)**
Inventor: **Tiedje, John Thomas**
**290 Hemlock Avenue**
**Garwood New Jersey 07027 (US)**

(74) Representative: **Mitchell, Alan et al**
**ESSO Engineering (Europe) Ltd. Patents & Licences Apex Tower High Street**
**New Malden Surrey KT3 4DJ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 122 047 B1

**Description**

This invention relates to multi-layered material comprised of amorphous semiconductor or insulator material.

Layered crystalline semiconductor materials with periodic variations in composition in one dimension on the scale of 0.5—50 nm (5—500A) commonly known as superlattice structures (Esaki U.S. 3,626,257) have been found to exhibit many novel properties with numerous technological applications. In these materials good semiconducting properties, such as carrier mobilities and minority carrier lifetimes that are comparable to high quality bulk samples of the individual components require that successive layers be grown epitaxially as single crystal sheets. This requirement is not easy to satisfy in practice and normally limits the composition of crystalline semiconductor superlattices to semiconductors and semiconductor alloys that are lattice matched or nearly lattice matched, and that can be deposited stoichiometrically by the techniques of thin film deposition. The degree of crystallinity of the superlattice material is then limited by the perfection of the substrate material and the ability of the deposited layers to replicate the underlying layers.

A further complication well-known in the art (see for example Dingle U.S. 4,261,771) is that even if the individual semiconductors comprising the intended superlattice material are lattice matched and can be deposited epitaxially as stoichiometric films, standard growth conditions still may not produce a superlattice material with substantially smooth layers since surface diffusion effects and nucleation effects may cause the semiconductor layers to grow in a columnar fashion or otherwise non-uniformly in the lateral direction perpendicular to the plane of the substrate. In this case it is unlikely that layered semiconductor films could be fabricated comprising individual sublayers that are coherent laterally and substantially smooth on the scale of a few interatomic distances. The mechanisms of thin film nucleation and growth are characteristically complex, in that they depend frequently in unexpected ways on the growth conditions such as the substrate temperature and the detailed structure and chemistry of the substrate surface. Thus, in general, one cannot predict what classes of materials or growth conditions can be used to fabricate superlattice structures.

Two classes of modulated crystalline superlattice materials have been studied in the prior art. In the first class (compositional modulation), $GaAs/Ga_{1-x}Al_xAs$ being an example, the indvidual sublayers comprise two different semiconductor materials or alloys with different physical properties such as band gap, melting point or resistance to ionic diffusion. In the second class (doping modulation), GaAs nipi structures being an example, the individual sublayers differ only in the concentration of electricly active dopant atoms. Superlattice materials in this category include n-i-p-i...p-i-p-i ..., n-i-n-i ..., p-n-p-n ... structures where n, i, and p are n-type, intrinsic and p-type sublayers. Examples of energy band diagrams for the two classes of superlattice materials described above are shown in Fig. 1 and 2.

Figure 1 shows a schematic energy-band diagram of a superlattice structure having undoped crystalline layers where the alternating layers have substantially different compositions and the thickness of each layer is d/2.

Figure 2 shows a schematic energy-band diagram of a superlattice structure having alternating layers, whose composition differs only in the dopant content, such as would be obtained in a n-i-p-i-n-i-p-i -structure for example. See, for example, L. Esaki et al., U.S. 3,626,357 and R Dingle et al., U.S. 4,163,237.

Another advance in the field of materials science relating to semiconductor technology in recent years has been the discovery that amorphous semiconductors and insulators can be deposited by a variety of means, reactive sputtering and plasma-assisted chemical vapor deposition (PCVD) being the most popular, in the amorphous state in a substantially defect-free form (PCVD is also known as glow discharge deposition). By substantially defect-free we mean free of chemically and electrically active coordination defects such as dangling bonds, to a level of better than about 1 defect per $10^3$ atoms. This defect-free property manifests itself as a low density of states in the gap, as measured for example, by the optical absorption coefficient for photons with an energy less than the optical bandgap. In one of the more thoroughly studied materials, namely amorphous silicon deposited by plasma assisted CVD from silane gas, the low density of defects is known to result from the passivation of dangling Si bonds by atomic hydrogen. The hydrogen content of these materials depends on the deposition conditions. The materials will be represented by the nomenclature a-Si:H, in the case of amorphous hydrogenated silicon, where the hydrogen content is understood to depend on the detailed nature of the film preparation process.

Prior to the present invention it was not known whether superlattice materials with substantially smooth, sub-layers, only a few atomic layers thick (0.5—50 nm), can be fabricated from amorphous semiconductors and insulators while simultaneously maintaining their substanially defect-free properties.

In view of the non-equilibrium nature of the growth process and the amorphous surface structure of these thin film amorphous semiconductors, prior to the present invention it was not known whether contiguous layers of different composition, a small number of atomic layers thick, can be deposited with long range ordering, that is considered over lateral distances which are large relative to the layer thickness (even though on an atomic scale the atoms are bonded in the amorphous structure without any long range

crystallographic order). Furthermore, if an amorphous superlattice material could be fabricated it is now known what the nature of the physical properties of this material would be. For example one of the most basic properties of a material namely the electronic energy level positions, can be calculated for crystalline semiconductors in terms of band theory which relies on the nearly perfect periodicity of the crystalline structure. In this case, the material properties can in principle be determined from the relevant electronic states and the band structure.

However, in amorphous materials the electronic energy levels cannot be calculated from the therory in the usual way because of the absence of long range periodicity. Although various alternative approaches have been tried with varying degrees of success, generally the theoretical work has at best succeeded only in describing known properties, without successfully predicting novel properties. Thus, it is not known how to predict the physical and chemical properties of an amorphous semiconductor material in which a periodic potential due to the superlattice structure is imposed in addition to the random atomic potentials of the underlying amorphous network.

The consequences for the material properties of a periodic superlattice potential of predetermined magnitude and periodicity, possibly of nearly atomic dimensions, superimposed on the random atomic potentials, is not known.

The amorphous superlattice materials have a variety of uses in optical and electronic applications· as in the case of the crystalline superlattice materials. They can be used for example as antireflection coatings and optical filters.

According to the invention there is provided a composition of material comprising a multilayer structure of amorphous material in which the layers forming the structure are made of semiconductor or insulator material with conduction and valence band edge energies that are spatially periodic due to compositional or doping modulation associated with the individual layers, the layers of said structure being less than 150 nm thick and being arranged as a repeating sub-unit of at least two layers and said material being formed from tetrahedrally bonded elements or alloys containing said tetrahedrally bonded elements.

The present invention can be put into effect to provide a new class of substantially defect-free, amorphous semiconductor materials which include an artifically produced superlattice. In addition, the present invention can provide amorphous semiconductor superlattice materials in which the physical properties, such as the optical bandgap, and resistivity can be controlled by changing the thickness of constituent sublayers. Furthermore, the present invention allows the fabrication of thin, substantially smooth and defect-free amorphous semiconductors and insulators that can be deposited to form an amorphous superlattice material without the need for lattice matching and epitaxial growth of the individual constituent materials.

For a better understanding of the invention and to show how the same may be carried into effect, reference will now be made, by way of example, to the accompanying drawings, wherein:—

Fig. 1 shows a schematic energy band diagram for electrons and holes in semiconductor superlattice material, in which the compositional modulation is due to alloying or other gross compositional variation.

Fig. 2 shows an energy band diagram for a semiconductor superlattice material in which the compositional modulation is associated with doping.

Fig. 3 is a schematic diagram of one form of superlattice structure in accordance with the invention.

Fig. 4 is a schematic diagram of the position of the individual atoms in the superlattice structure.

Fig. 5 is a schematic diagram of a plasma assisted chemical vapor deposition reactor.

Fig. 6 shows optical absorption coefficient for four

$$a\text{-Si:H/a-Si}_{1-x}\text{:H}$$

superlattice materials where the

$$a\text{-Si}_{1-x}N_x\text{:H}$$

sub-layer thickness is held at 35A and the a-Si:H sub-layer thicknesses have the indicated values. Also shown is the optical absorption coefficient of a homogeneous a-Si:H film and a homogeneous

$$a\text{-Si}_{1-x}N_x\text{:H}$$

film grown under the same conditions as in the superlattice materials.

Fig. 7 shows the normalized resistivity, optical gap, $E_g$, and energy of the peak in the photoluminescence emission, PL, as a function of a a-Si:H sub-layer thickness L, plotted as $L_{-2}$, for a series of

$$a\text{-Si:H/a-Si}_{1-x}N_x\text{:H}$$

superlattice materials where the

$$a\text{-Si}_{1-x}N_x\text{:H}$$

sub-layer thickness is held fixed at 3.5 nm.

Fig. 8 shows the electrode configuration used in measurements of the in-plane resistivity of superlattice materials.

Fig. 9 shows the optical absorption coefficient as a function of photon energy for an amorphous superlattice material comprising about ten periods of 150 nm (1500A) a-Si:H sub-layers and 3.5 nm (35A)

$$a\text{-Si}_{1-x}N_x\text{:H}$$

sub-layers. The weakly energy dependent absorption at low photon energies is associated with structural defects.

Fig. 10 is a graph of the characteristic X-ray diffraction pattern of a layered amorphous semiconductor superlattice material.

Fig. 11 shows a transmission electron microscope picture of a thin section of an amorphous semiconductor superlattice material wherein the repeat distance is 5 nm (50A).

Referring firstly to Fig. 3 there is shown a schematic diagram of a composition of matter which comprises a multilayered material whose layers are thin sheets of semiconducting or insulating tetrahedrally bonded amorphous material where the material is formed from tetrahedrally bonded elements or alloys containing said tetrahedrally bonded elements. Each layer is less than 150 nm (1500A) thick. In a preferred embodiment, the entire layered structure is a thin film material, that is a material than is less than about 10 microns thick. The first and alternate layers 1, 3, 5 of the structure have the same given composition while the second and alternate layers 2, 4, 6...have the same composition different from the given composition of 1, 3, 5.... Therefore, the multilayered material can be regarded as a repeating sub-unit of two layers having different compositions and the spatial repeat distance associated with the repeating sub-units is the thickness of layer 1 plus layer 2. That is, layer 3 plus layer 4 is a repeat of layer 1 plus layer 2, etc.

The optical bandgap (as discussed below) of the composition differs from that of materials comprising the individual layers. In a preferred embodiment, the repeat distance is less than 100 nm (1000A).

The layers of the composition are substantially uniform in thickness. By substantially uniform in thickness, it is meant that the layer thicknesses vary by less than a few mono-layers of 10% (whichever is larger) over lateral distances equal to several times the layer thickness.

A description of the electronic energy levels in terms of well-defined E vs k relations, where E is the electronic energy and k is its wave-vector, is not possible in amorphous semiconductors in the same way as it is in crystalline semiconductors. Nevertheless, some general features of the electronic energy level spectrum are known to be the same in both crystalline and low defect density amorphous semiconductors. For example, both types of semiconductors have a gap in the density of states between a broad distribution of filled levels (the valence band) and a broad distribution of empty levels (the conduction band). In crystals these energy bands have relatively sharp edges, broadened only by the thermal motion of the crystal lattice. In amorphous semiconductors the density of states edges are broader, being broadened by the structural disorder of the amorphous network in addition to the thermal motion of the atoms. The width of the low energy absorption tail of the optical absorption edge is one measure of the sharpness of the band edges in amorphous or crystalline semiconductors. In any case, an objective measure of the position of the band edges can be defined for both crystalline or amorphous semiconductors by, for example, the energy at which the density of states of the bulk material drops to $10^{20}cm^{-3}ev^{-1}$. In this sense, energy band diagrams such as those shown in Figs. 1 and 2, as described above can equally well be applied to amorphous and crystalline semiconductors. The modulation in the band edge energies illustrated in Figs. 1 and 2 is obtained by modulation of the thin film composition.

The interfacial regions between the layers of the composition of matter are substantially defect free. Referring to Figure 4 shows a schematic diagram of the lattice structure in which the atoms of the alternating layers are indicated by light and dark circles. The period of the structures is d. As indicated in Figure 4, there are substantially no dangling bonds to give rise to defects at the interfaces. The long range ordering of the layers can be appreciated from Figure 4.

Examples of amorphous semiconducting and insulating materials that can be fabricated into amorphous semiconductor superlattices can be divided into two classes:

(1) Group IVA elements and alloys include:

a-Si:H, a-Ge:H, a-$Si_{1-x}C_x$:H, a-$Si_{1-x}Ge_x$:H, a-$Si_{1-x}$-$N_x$:H, a-$Si_{1-x}Sn_x$H, a-$Si_{1-x}$:H, a-C:H (tetrahedrally coordinated) a-$Si_{1-x-y}O_xN_y$:H plus alloys and halogenated (F, Cl) versions of the hydrogenated materials listed. (e.g. a-$Si_{1-x-y}Ge_xSn_y$iHiF).

(2) Group IVA elements and alloys doped with group IIIA and VA elements

Suitable n type dopants include N, P, As, Sb, and suitable p type dopants include B, Al, Ga, In, Tl.

As used herein, the subscripts are the atomic fractions of the elements in the material. For example, if x=2/3, then a-$Si_{1-x}O_x$:H is a-$Si_{1/3}O_{2/3}$:H which is a-$SiO_2$:H.

Layers 1, 3, 5 ... and layers 2, 4, 6 ... may comprise any two of the materials where both are selected from the same class, e.g. a-Si:H/a-$Si_{1-x}N_x$:H or n-doped a-Si:H/p-doped a-Si:H.

In addition the alternating layers may include one material from class 1 alternating with a material from class 2, e.g. a-Si:H/n-doped a-$Si_{1-x}N_x$:H.

The composition also includes layered materials of the form n-i-p-i-n-i-p-i, where n and p are n-doped and p-doped material derived from an undoped amorphous semicoductor material, i, by the addition of small concentrations of n and p-type dopant, respectively and the unit n-i-p-i is regarded as a repeating sub-unit of the amorphous multilayer structure. In this case, each layer 1, 3, 5 ... is considered to be n-i and each layer 2, 4, 6 ... is considered to be p-i so that the spatial repeat distance associated with the

repeating sub-units is the thickness of n-i-p-i.

The composition of matter also includes layered materials where the composition of each layer is modulated across the layers. For example, if the alternating layers are a-Si:H and a-Ge:H alloys, the transition from a-Si:H to a-Ge:H and from a-Ge:H to a-Si:H may occur gradually over the layer thicknesses starting with a-Si:H, gradually increasing the percentage of a-Ge:H until it is all a-Ge:H. In the next adjacent layer, the percentage of a-Si:H is increased until it is all a-Si:H. All succeeding layers repeat this sequence.

The materials in the two groups can be prepared by glow dischange decomposition of gaseous mixtures of volatile hydrides, fluorides or chlorides or of the elemental gases themselves in the case of $O_2$, $N_2$, $Cl_2$ and $F_2$, as described below.

Material preparation

There are several deposition processes that are known to produce low defect density amorphous semiconductors. These include PCVD, low temperature CVD and sputtering. Low temperature CVD is restricted to reactive gases that decompose at relatively low temperature such as for example $Si_2H_6$. Sputtering has the advantage of being capable of producing a wider variety of amorphous semiconductor materials than can be made by PCVD or CVD, however, sputtered films usually contain more defects than PCVD films. We describe here a method for using PCVD to make amorphous semiconductor superlattices. To make amorphous semiconductors superlattices by CVD we simply omit the electric discharge used in the PCVD technique. To make amorphous semiconductor superlattices by sputtering it is possible to modify the technique (A. H. Eltoukhy and I. E. Greene *J. Appl. Phys. 50*, 505 (1979)) for making crystalline semiconductor superlattices by changing the deposition conditions (e.g. substrate temperature, gas pressure and addition of $H_2$ to the plasma discharge) to produce hydrogenated amorphous rather than crystalline semiconductors.

Referring to Figure 5 a PCVD apparatus for carrying out the fabrication of the composition of matter is designated as 2. The PCVD apparatus includes a vacuum chamber typically of stainless steel. In the vacuum chamber 4 are electrodes 6 and 8. Electrode 6 is grounded and referred to as the anode. Electrode 8 is insulated from the stainless steel chamber by insulator 10 and is referred to as the cathode. Flat heaters 12 are contained in the electrodes. Substrates 14 which can be insulators such as quartz or metals such as stainless steel are placed in good thermal contact with the electrodes.

The plasma is produced by a low power (5—10 W) RF (13.5 MHz) discharge, by means of an RF generator 16 connected to the cathode. To deposit layered films the composition of the gas in the reactor 2 is changed periodically by opening and closing alternately pneumatic valves 18 and 20 to admit gas A or gas B into the reactor.

In order to avoid setting up pressure transients through the opening and closing of valves 18 and 20 the gases A and B are alternatively shunted into a ballast pump 26 by opening and closing valves 22 and 24 in phase with valves 18 and 20, respectively. The gases are pumped continuously out of the reactor by a pump through outlet 28.

To achieve abrupt changes in composition between adjacent layers requires that the time it takes to change gases in the reactor (molecular residence time) be short compared to the time it takes to grow a monolayer. The molecular residence time τR is given by

$$\tau R = \frac{Vp}{F_o p_o}$$

where V is the volume of the reactor, p is the gas pressure in the reactor and $F_o$ is the gas flow rate at standard pressure $p_o$. $\tau_R$ can be varied over a wide range of values. In our experiments we have used V=30 liters, p=4 Pa (30 m torr), $F_o$=0.1 liter/min which gives $\tau_R$=1 sec. with a typical deposition rate of 1Å/sec. the transition from one layer to the next takes place over a distance of less than a single atomic layer. The sublayer thickness is given by the product of the deposition rate and the flow period of the gas. The thickness of the sublayers can be varied from a submonolayer to thousands of angstroms.

Examples of amorphous semiconductor superlattice that have been produced include:

a-Si:H/a-Ge:H
a-Si:H/a-$Si_{1-x}N_x$:H
a-Si:H/a-$Si_{1-x}C_x$:H

The a-Si:H sublayers were made from pure $SiH_4$. The Ge:H sublayers were made from a mixture of 10% $GeH_4$+90% $H_2$. The a-$Si_{1-x}C_x$:H sublayers were made from a mixture of 50% $SiH_4$+50% $NH_3$. The a-$Si_{1-x}N_x$:H layers were made from a mixture of 20% $SiH_4$+80% $NH_3$. The substrate temperatures were in the range 200—250°C.

Amorphous semiconductor n-i-p-i, p-i-p-i, p-n-p-n, n-i-n-i superlattice structures can be formed by any of the methods described above by changing periodically the dopant concentration in the gas. For example by flowing into the reactor first $SiH_4$+1% $PH_3$, then $SiH_4$ and then $SiH_4$+1% $B_2H_6$ and repeating this sequence periodically we obtain an amorphous semiconductor n-i-p-i superlattice.

The novel properties of the composition of matter are believed to be due to the quantum effects brought about by the dimensions of the layered material. The quantum effects manifest themselves in the optical and electrical properties of the material. Some of these physical properties are discussed below. The quantum effects brought about by the dimensions of the layered material are expected to have an appreciable effect on the properties of the material only if the

energy level shifts introduced by the quantum effect are greater than about kT, where T is the temperature at which the properties are measured (~25 mev at room temperature).

Optical properties

The optical properties of a variety of

$$a\text{-}Si{:}H/a\text{-}Si_{1-x}N_x{:}H$$

superlattice materials have been investigated. The optical absorption coefficient $\alpha$ as a function of photon energy E is shown in Figure 6 for four different superlattice materials all with the same

$$a\text{-}Si_{1-x}N_x{:}H$$

sublayer thickness (~3.5 nm) but with the a-Si:H sublayer thickness varying from about 5 nm (50A) to about 1 nm (10A). By extrapolating to $\alpha=0$ a linear fit to the optical absorption data plotted as $(\alpha E)^{1/2}$ as a function of E, where E is the photon energy, as is customarily done in the amorphous semiconductor field to determine optical bandgaps, we found that the optical gap increased by about 0.5 ev when the a-$SiH_x$ sublayer thickness was reduced from 5 nm (50A) to 1 nm (10A). It is worth noting that the above-mentioned method for determining the optical gap involving the extrapolation of $(\alpha E)^{1/2}$ to $\alpha=0$ is not dependent in any essential way on an accurate knowledge of the thickness of the deposited film.

Also shown in Figure 6 is the optical absorption coefficient for a film comprising only a-Si:H deposited under the same conditions as in the superlattice and a film comprising only

$$a\text{-}Si_{1-x}N_x{:}H$$

also deposited under the same conditions as in the superlattice film. Note that the optical absorption of the superlattice materials cannot be represented as a linear combination of the two constituents. Not only does the magnitude of the optical gap change with a-Si:H sublayer thickness, but also the slope of the low energy exponential part of the absorption edge changes with a-Si:H layer thickness, as illustrated in Fig. 6.

The increase in optical gap for the material with decreasing layer thickness is believed to be associated with the quantum confinement of conduction band electrons into two dimensional potential wells formed by the

$$a\text{-}Si_{1-x}N_x{:}H/a\text{-}Si_{1-x}N_x{:}H$$

sandwiches, as illustrated schematically in Figure 1. In the limiting case that the potential wells are infinitely deep (infinitely large bandgap a-$Si_{1-x}N_x$:H) the optical gap of the superlattice material would be expected to be wider than the optical gap of bulk a-Si:H by $h^2/8m^*L^2$ where h is Planck's constant, m* is the effective mass for electrons in a-Si:H and L is the a-Si:H sublayer thickness. Thus, in this interpretation the optical bandgap would be a linear function of $1/L^2$.

A plot of the optical gap $E_g$ as defined above vs, the reciprocal of the square of the a-Si:H sublayer thickness is shown in Figure 7. Note that the optical gap is not a linear function of $1/L^2$ as predicted by the simple theory, rather being sublinear. Nevertheless, the magnitude of the total change in the optical gap with layer thickness is consistent with a physically reasonable electronic effective mass m* ($0.1\ m<m^*\leq 1.0\ m$ where m is the free electron mass).

Also plotted in Figure 7 is the energy of the peak of the photoluminescence emission band for the same superlattice films. Although the energy of the emission peak increases as L decreases, the L dependence is much weaker than the corresponding L dependence for the optical gap also shown in Figure 7. The origin of this difference in behavior is unknown. It could be associated with the fact that a two dimensional excitation is four times more strongly bound than a three dimensional excitation, or it may be simply an indication that the distribution of band tail states is broadened by the two dimensional potential wells introduced by the compositional modulation of the superlattices.

Electrical properties

The electrical resistivity of a series of

$$a\text{-}Si{:}H/a\text{-}Si_{1-x}N_x{:}H$$

superlattice materials has been studied, both the resistivity in the plane of the sublayers and the resistivity perpendicular to the sublayers. The resistivity in the plane of the sublayers was determined using the sample configuration and electrode pattern shown in Figure 8. The superlattice material was deposited on two predeposited $Cr/n^+9$-Si:H fingers, through a circular (5 mm diameter hole) shadow mask spaced a few tenths of a millimeter above the substrate so as to produce a tapered thickness penumbra a few tenths of a millimeter wide around the perimeter of the film. This approach ensures electrical contact to all of the sublayers in the sometimes highly anisotropic superlattice materials. Perpendicular resistivity measurements were performed on films deposited on $Cr/n^+$a-Si:H coated quartz substrates, which forms an ohmic contact to a SiH. A similarly ohmic contact was made to the top surface of the superlattice film with 2 $mm^2$ area $Cr/n^+$a-Si:H dots.

The room temperature resistivity in the plane of the sublayers is plotted in Figure 7 as a function of $L^{-2}$ for the same series of

$$a\text{-}Si{:}H/a\text{-}Si_{1-x}N_x{:}H$$

superlattice materials which had been studied optically. The resistivity in Figure 7 is normalized to the resistivity of the superlattice with the thickest a-Si:H sublayer, which was 1500A thick.

If the Fermi level in the superlattice material remains fixed relative to the edge of the valence

band independent of the superlattice size parameter L and the conductivity is due to electrons rather than holes, then the in-plane resistivity is expected to depend on the band gap through the exponential relation $\rho=\rho_o \exp(E/kT)$. Provided the optical gap is a good measure of the band gap, a plot of $kT\ln(\rho/\rho_o)$ as a function of $1/L^2$ should parallel the optical gap. The logarithmic resistivity scale on the righthand vertical axis in Figure 3 has been appropriately scaled so that $kT\ln(\rho/\rho_o)$ in electron volts corresponds to the energy scale in electron volts for the optical gap on the left hand vertical axis. Note that the resistivity increases more rapidly with decreasing superlattice parameter L than expected on the basis of the optical gap alone.

One speculative explanation for the difference between the optical gap and the gap inferred from the resistivity, is that the mobility gap, which is the relevant quantity as far as the resisivity is concerned, increases more rapidly with the two dimensional quantum confinement, than the density of states gap.

The anisotropy in the electrical resistivity, of the

$$a\text{-}Si{:}H/a\text{-}Si_{1-x}N_x{:}H$$

superlattice materials namely the ratio of the perpendicular resistivity to the in-plane resistivity, varied from $>10^8$ for the thick a-Si:H sublayer material to order 10—100 in the thin a-Si:H sublayer material. The larger anisotropy for the large L material where L is the thickness of the a-Si:H sublayers ($a\text{-}Si_{1-x}N_x{:}H$ sublayer held at 35A) confirms the x-ray structural results, namely that thin, laterally coherent amorphous films have been fabricated. The reduction in anisotropy for the small L material results from the much larger in-plane resistivity in this material.

## Density of defects

The magnitude of the optical absorption coefficient for photon energies less than the optical absorption threshold is a commonly used figure of merit in the characterization of the defect density in semiconductor materials. In a-Si:H, it is well-known that structural defects such as dangling bonds show up as a low energy absorption shoulder whose magnitude is proportional to the density of defects. the optical absorption coefficient in the weakly absorbing subbandgap region is most easily determined from the photoconductivity response spectrum as measured using the technique of Triska et al. (Sol. State Commun. 1981) for example. The absolute magnitude of the low energy absorption is then determined by a match of the high energy part of the photoconductivity spectrum to optical transmission measurements.

The optical absorption coefficient $\alpha$ determined as outlined above for photon energies in the vicinity of the optical gap and lower, is shown in Figure 9 for an amorphous semiconductor superlattice material comprising alternating 150 nm (1500 A) a-Si:H layers and 3.5 nm (35A) $a\text{-}Si_{1-x}N_x{:}H$ layers. The oscillations in the optical absorption are caused by interference fringes generated by reflections at the film-substrate interface and the film-air interface. The optical absorption coefficient for the bulk material is the average of the interference maxima and minima on a logarithmic scale.

The optical absorption at 1.2 ev of about 3 $cm^{-1}$ in Figure 9, is equivalent to a density of defect states of order $10^{16}$ $cm^{-3}$/ev, which corresponds to approximately one defect in $10^7$ atoms. This defect density is comparable to the defect density in conventional nominally homogeneous a-Si:H films prepared under the same conditions.

## X-Ray properties

An important test of the structural perfection of layered amorphous semiconductors is their ability to diffract x-rays. The layered films act as a one dimensional diffraction grating, giving rise to characteristic diffraction according to Bragg's law:

$$2d \sin \phi_m = m\lambda$$

where $\phi_m$ is the Bragg angle corresponding to the $m^{th}$ order diffraction, d is the repeat distance of the superlattice and $\lambda$ is the wavelength of the x-ray.

In Figure 10 is shown the characteristic diffraction pattern of an amorphous semiconductor superlattice consisting of 40 periods deposited on a quartz substrate. Each period consists of a 4 nm (40Å) thick sublayer of

$$a\text{-}Si{:}H/a\text{-}Si_{1-x}N_x{:}H$$

and a 3 nm (30Å) thick sublayer of

$$a\text{-}Si_{1-x}N_x{:}H.$$

The x-ray measurements were made with $\lambda$=0.154 nm (1.54Å). The sharpness of the peaks and the magnitude of the higher order reflections provide evidence that the layers are of uniform thickness, smooth and parallel.

In the case of perfectly smooth and parallel layers the magnitude of the m order reflection, R, is given by (see e.g. J. H. Underwood and T. W. Barber P. 170 of the proceedings of the AIP in conference (1981))

$$R_m=(\text{constant})\left[\frac{\sin\left(\frac{md_1}{d}\right)\pi}{m^4}\right]^2$$

where $d_1$ and $d_2$ are the thickness of the two sublayers forming the superlattice ($d=d_1+d_2$). If the layers are rough then the higher harmonics are attenuated according to the expression

$$R'_m=R_m \exp\left[-\left(\frac{Lm\pi}{d}\xi\right)^2\right]$$

where $R'_m$ is the mth order reflection for the rough superlattice and ξ is the RMS roughness of the layers. By applying the above two equations to our x-ray data we obtained an RMS roughness ξ=0.5 nm (5Å) which is less than two monolayers.

Transmission microscopy

Another way of checking the perfection of the superlattice is by transmission electron microscopy of a thin section perpendicular to the layers.

Referring to Fig. 11 shows a transmission electron microscope picture of a layered

$$a\text{-}Si:H/a\text{-}Si_{1-x}N_x:H$$

amorphous semiconductor superlattice material with a periodic repeat distance of about 5 nm (50Å). This figure further demonstrates the existence of laterally continuous, substantially smooth layers.

**Claims**

1. A composition of matter comprising a multilayer structure of amorphous material in which the layers forming the structure are made of semiconductor or insulator material with conduction and valence band edge energies that are spatially periodic due to compositional or doping modulation associated with the individual layers, the layers of said structure being less than 150 nm thick and arranged as a repeating sub-unit of at least two layers and said material being formed from tetrahedrally bonded elements or alloys containing said tetrahedrally bonded elements.

2. A composition of matter according to claim 1 with a periodic repeat distance associated with said repeating sub-units of less than 150 nm (1500 A).

3. A composition of matter according to either of claims 1 and 2 wherein said multilayer structure has an optical bandgap which differs from that of materials comprising the indvidual sublayers.

4. A composition of matter according to any one of the preceding claims wherein said layers are substantially defect free.

5. A composition of matter according to any one the preceding claims wherein said layers are substantially smooth and of uniform thickness across each layer.

6. A composition of matter according to any one of the preceding claims wherein the first and alternate layers of said multilayered structure have the same given composition and the second and alternate layers of said structure have the same composition different from said given composition.

7. A composition of matter according to any one of the preceding claims wherein said first and alternate layers comprise a tetrahedrally bonded element from Group IVA of the periodic table, or an alloy containing said tetrahedrally bonded elements.

8. A composition of matter according to any one of the preceding claims wherein said first and alternate layers are an intrinsic amorphous semiconductor material, i, and said second and alternate layers are a doped material derived from said i material.

**Patentansprüche**

1. Stoffzusammensetzung mit einem Mehrschichtaufbau aus amorphem Material bei dem die den Aufbau bildenden Schichten aus Halbleitermaterial oder aus Isolatormaterial bestehen und wobei sich die Leitfähigkeitsband- und Valenzband-Kantenenergien aufgrund ihrer Zusammensetzungsoder Dotierungsmodulation in den einzelnen Schichten periodisch wiederholen und die Schichten des Aufbaus weniger als 150 nm dick und als eine sich wiederholende Untereinheit von mindestens zwei Schichten angeordnet sind, während der Stoff von tetraedrisch gebundenen Elementen oder Legierungen, die tetraedrisch gebundene Elemente enthalten, gebildet ist.

2. Stoffzusammensetzung nach Anspruch 1, wobei der periodische Wiederholungsabstand, der zu den sich wiederholenden Untereinheiten gehört, weniger als 150 nm beträgt.

3. Stoffzusammensetzung nach Anspruch 1 oder 2, wobei der Mehrschichtaufbau eine optische Bandlücke besitzt, die sich von derjenigen der Stoffe unterscheidet, die die einzelnen Unterschichten aufweisen.

4. Stoffzusammensetzung nach einem der vorhergehenden Ansprüche, wobei die Schichten im wesentlichen defektfrei sind.

5. Stoffzusammensetzung nach einem der vorhergehenden Ansprüche, wobei die Schichten im wesentlichen glatt sind und über jede Schicht gleichmäßige Dicke haben.

6. Stoffzusammensetzung nach einem der vorhergehenden Ansprüche, wobei die erste und jede abwechselnd weitere Schicht des Mehrschichtaufbaus die gleiche vorgegebenen Zusammensetzung und die zweite und jede abwechselnd weitere Schicht des Aufbaus die gleiche sich von der vorgegebenen Zusammensetzung unterscheidende Zusammensetzung haben.

7. Stoffzusammensetzung nach einem der vorhergehenden Ansprüche, wobei die erste und jede abwechselnd weitere Schicht ein tetraedrisch gebundenes Element aus der Gruppe IVA des Periodensystems oder eine Legierung aufweist, die die tetraedrisch gebundenen Elemente enthält.

8. Stoffzusammensetzung nach einem der vorhergehenden Ansprüche, wobei die erste und jede abwechselnd weitere Schicht ein intrinsisches, amorphes Halbleitermaterial i sind und die zweiten und abwechselnden Schichten ein dotiertes Material sind, das von dem i-Material abgeleitet ist.

**Revendications**

1. Composition de matière comprenant une structure multicouche d'un matérieau amorphe, dans laquelle les couches formant la structure sont constituées d'un matériau semiconducteur ou isolant, avec des énergies de limite de bande de conduction et de bande de valence qui sont spatialement périodiques en conséquence de la modulation en composition ou en dopage associée aux couches individuelles, les couches de ladite structure ayant une épaisseur inférieure à 150 nm et étant disposées sous la forme d'une sous-unité répétitive constituée d'au moins deux couches, ledit matériau étant formé d'éléments à liaison tétraédrique ou d'alliages contenant lesdits éléments à liaison tétraédrique.

2. Composition de matière selon la revendication 1, avec une distance de répétition périodique, associée auxdites sous-unité répétitives, inférieure à 150 nm (1500 A).

3. Composition de matière selon la revendication 1 ou la revendication 2, dans laquelle ladite structure multicouche a une largeur de bande optique interdite qui différe de celle des matériaux constituant les sous-couches individuelles.

4. Composition de matière selon l'une quelconque des revendications précédentes, dans laquelle lesdites couches sont pratiquement exemptes de défauts.

5. Composition de matière selon l'une quelconque des revendications précédentes, dans laquelle lesdites couches sont pratiquement lisses et ont une épaisseur uniforme pour chaque couche.

6. Composition de matière selon l'une quelconque des revendications précédentes, dans laquelle la première couche, puis les couches d'ordre impair, de ladite structure multicouches, ont la même composition donnée, la deuxième couche, et les couches d'ordre pair, de ladite structure, ayant la même composition, différente de ladite composition donnée.

7. Composition de matière selon l'une quelconque des revendications précédentes, dans laquelle la première couche, et les couches d'ordre impair, comprennent un élément à liaison tétraédrique du groupe IVA du Tableau Périodique, ou un alliage contenant ces éléments à liaison tétraédrique.

8. Composition de matière selon l'une quelconque des revendications précédentes, dans laquelle ladite première couche, et les couches d'ordre impair, sont en un matériau semi-conducteur amorphe intrinsèque, i, la deuxième couche et les couches d'ordre pair étant en un matériau dopé dérivant dudit matériau i.

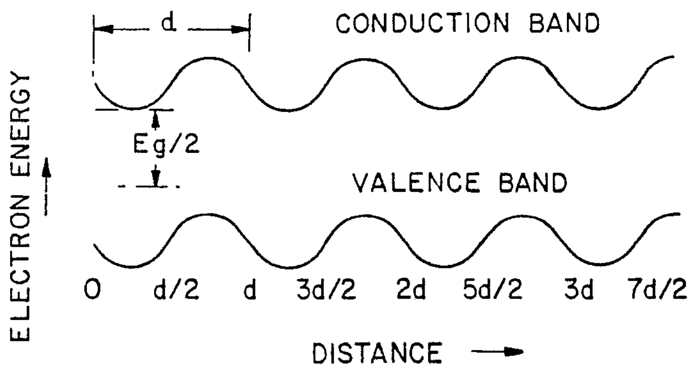


FIG. 2

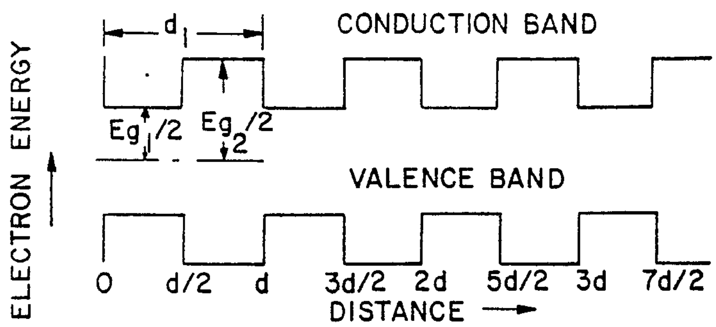


FIG. 1

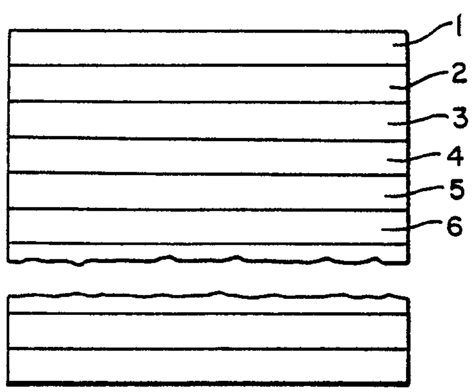


FIG. 3

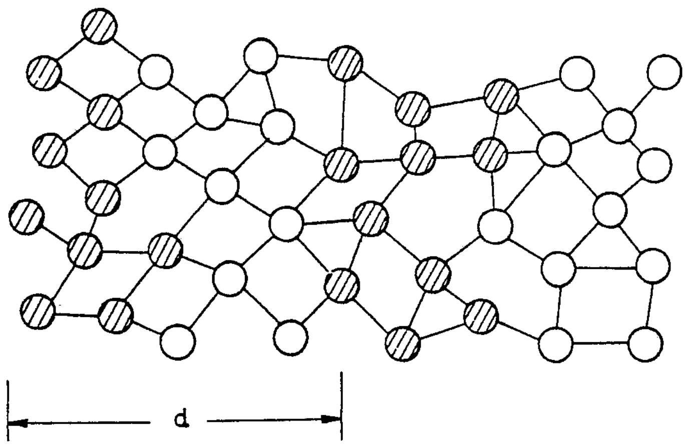


FIG. 4

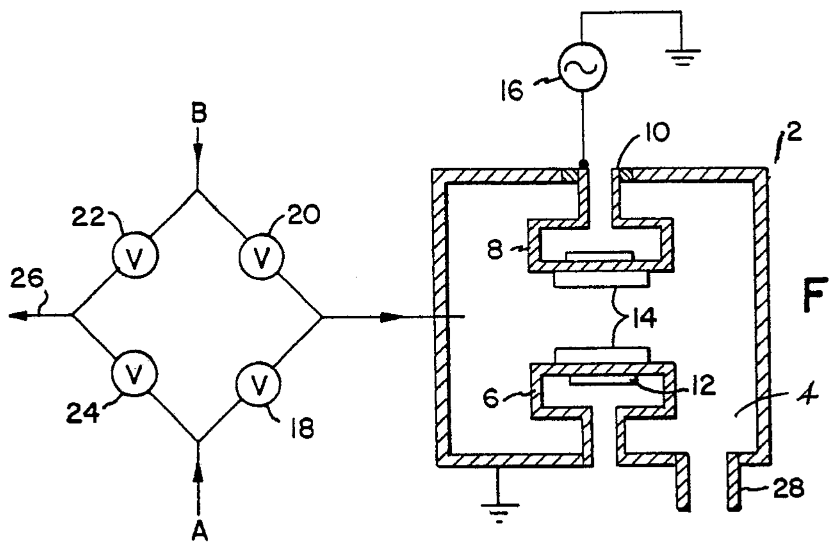


FIG. 5

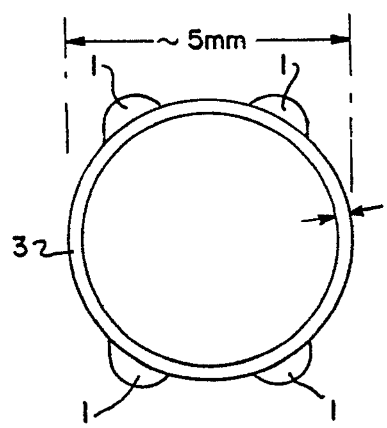


FIG. 8

FIG. 6

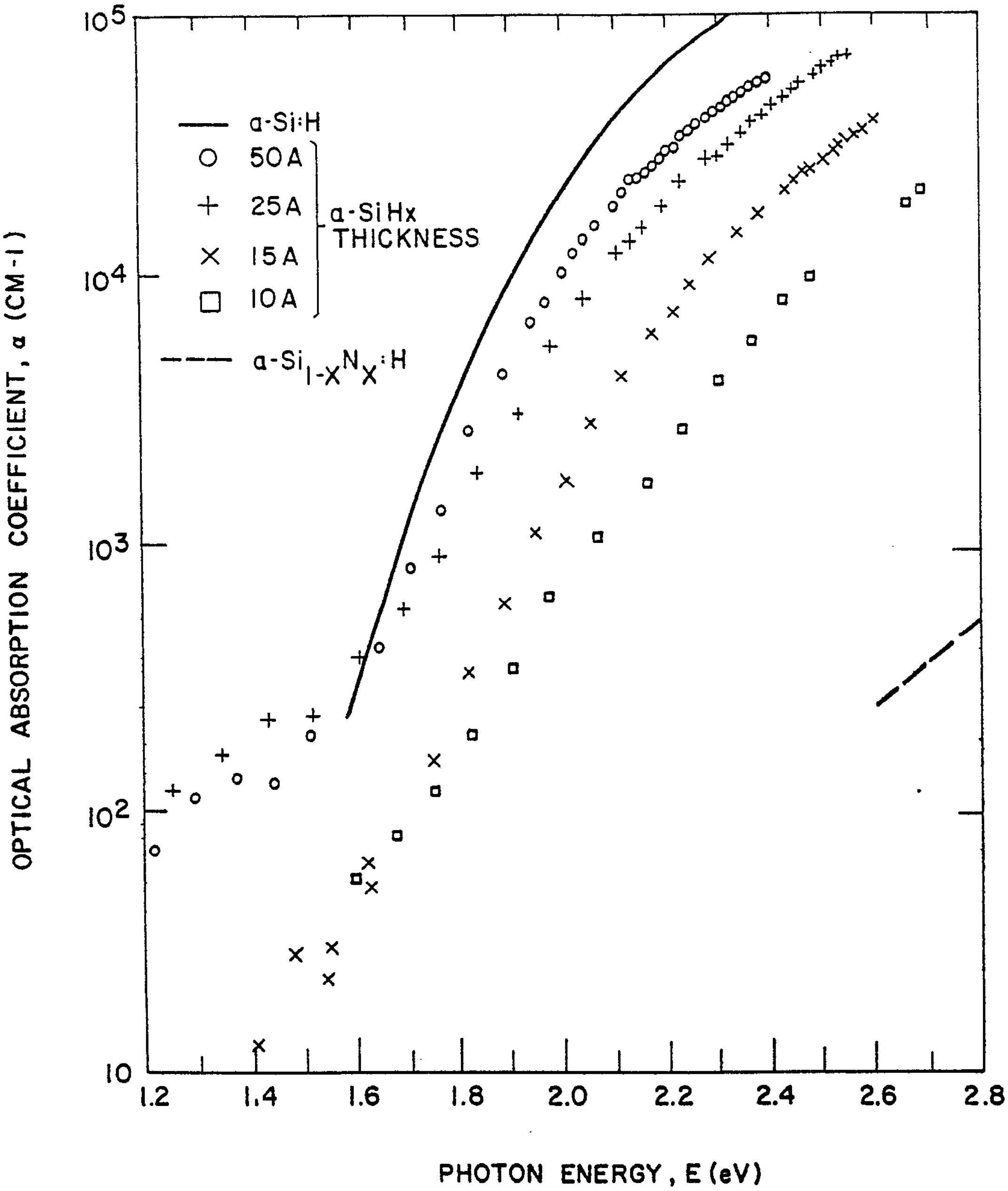
a-Si:H
50A
25A
15A
10A
a-SiHx THICKNESS
a-$Si_{1-X}N_X$:H
OPTICAL ABSORPTION COEFFICIENT, α (CM-1)
$10^5$
$10^4$
$10^3$
$10^2$
10
1.2
1.4
1.6
1.8
2.0
2.2
2.4
2.6
2.8
PHOTON ENERGY, E (eV)

FIG. 7

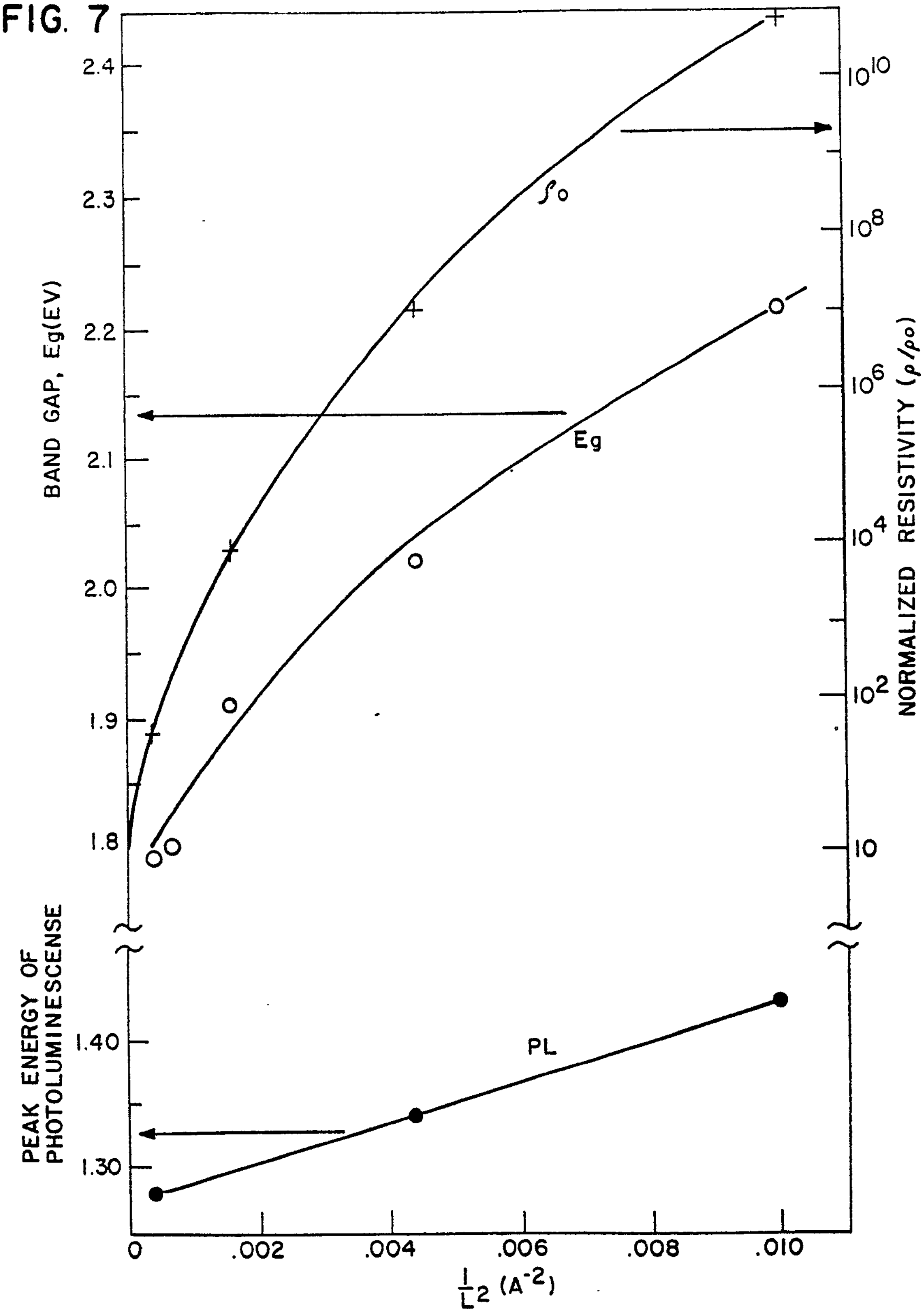
BAND GAP, Eg(EV)
2.4
2.3
2.2
2.1
2.0
1.9
1.8
PEAK ENERGY OF PHOTOLUMINESCENSE
1.40
1.30
$10^{10}$
$10^8$
$10^6$
$10^4$
$10^2$
10
NORMALIZED RESISTIVITY (ρ/ρo)
ρo
Eg
PL
0
.002
.004
.006
.008
.010
$\frac{1}{L^2}$ ($A^{-2}$)

FIG. 9

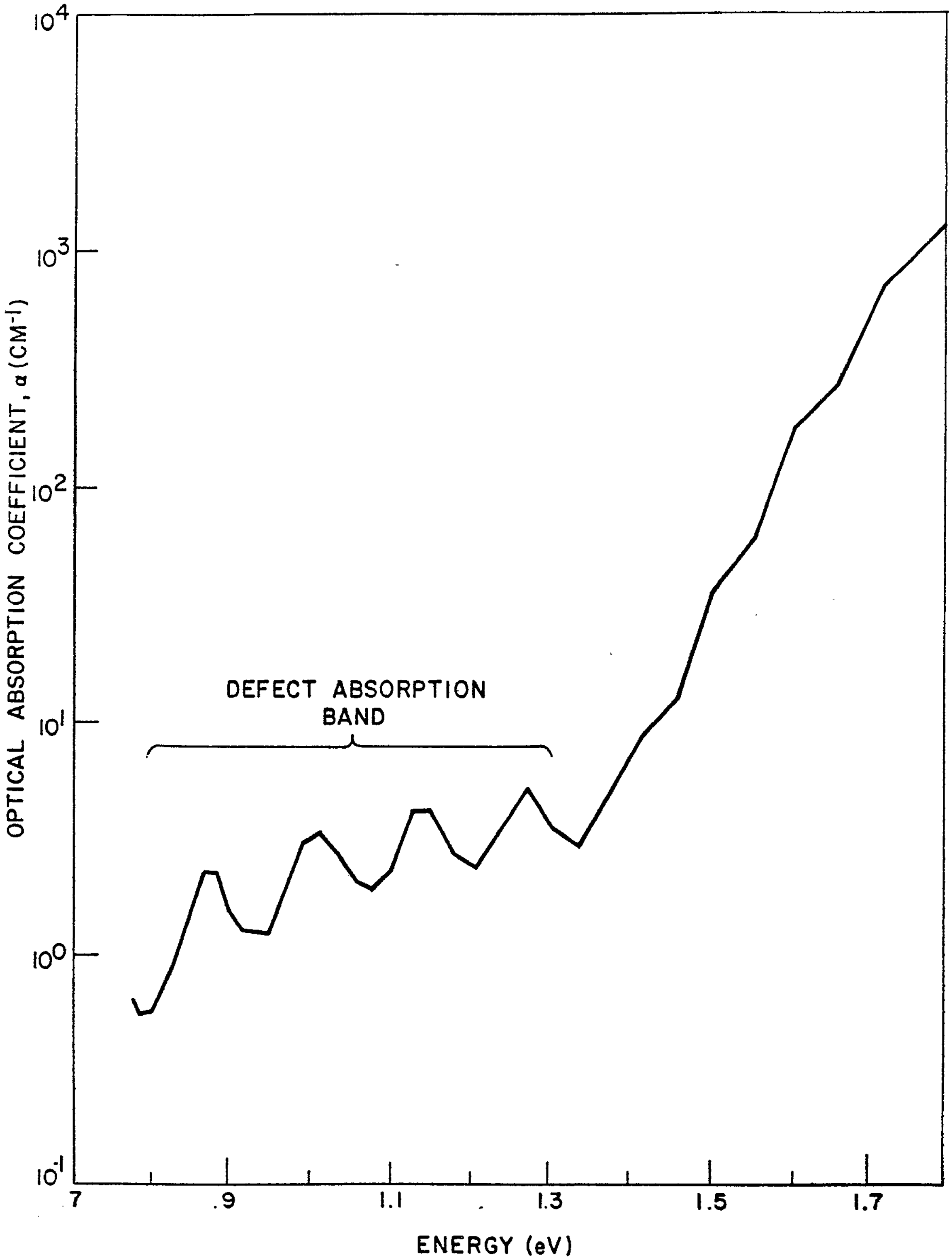
10^4
10^3
10^2
10^1
10^0
10^-1
OPTICAL ABSORPTION COEFFICIENT, α (CM^-1)
DEFECT ABSORPTION
BAND
.7
.9
1.1
1.3
1.5
1.7
ENERGY (eV)

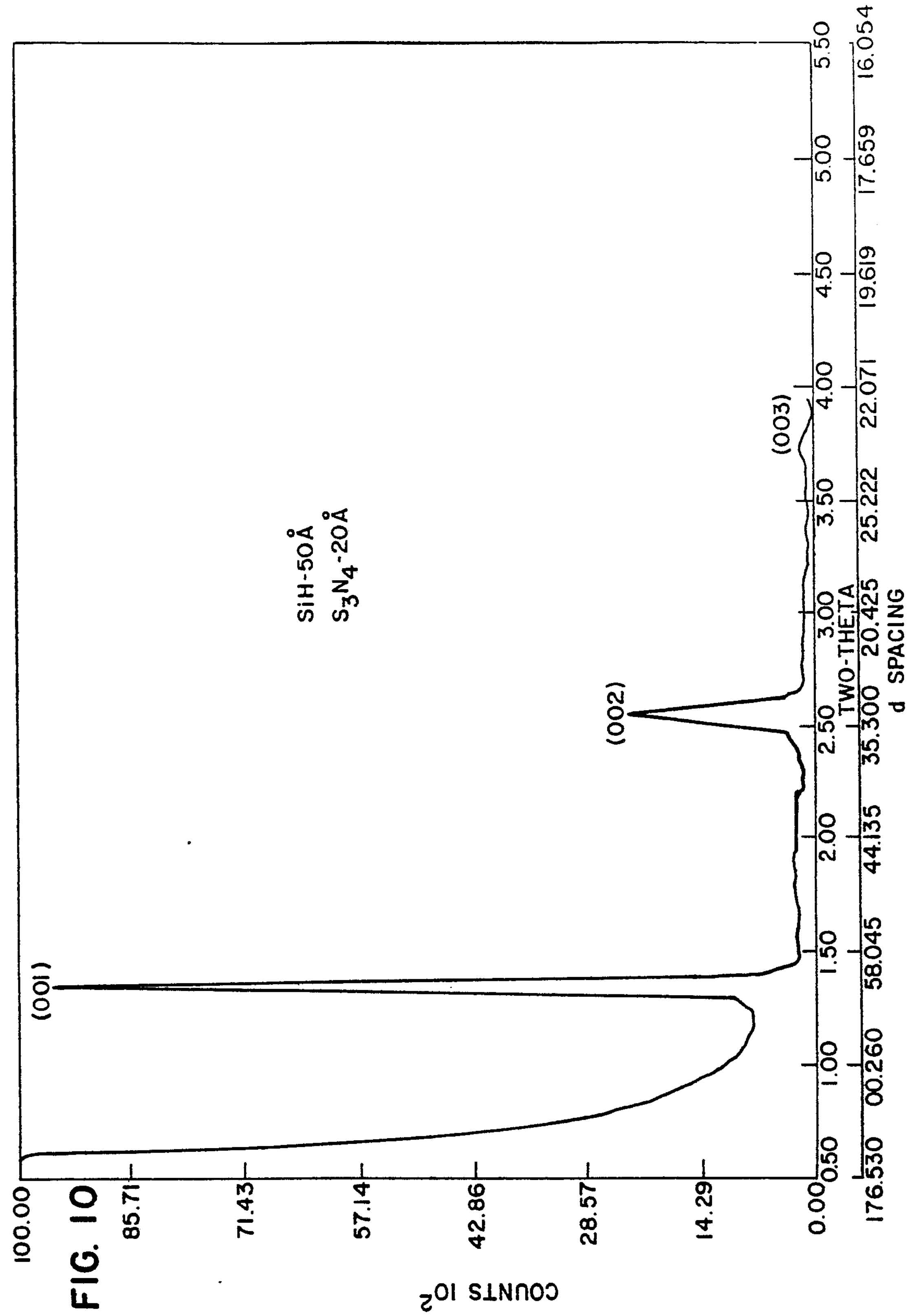
SiH-50Å
$S_3N_4$-20Å
(001)
(002)
(003)
COUNTS $10^2$
100.00
85.71
71.43
57.14
42.86
28.57
14.29
0.00
TWO-THETA
0.50
1.00
1.50
2.00
2.50
3.00
3.50
4.00
4.50
5.00
5.50
d SPACING
176.530
00.260
58.045
44.135
35.300
20.425
25.222
22.071
19.619
17.659
16.054

FIG. 10

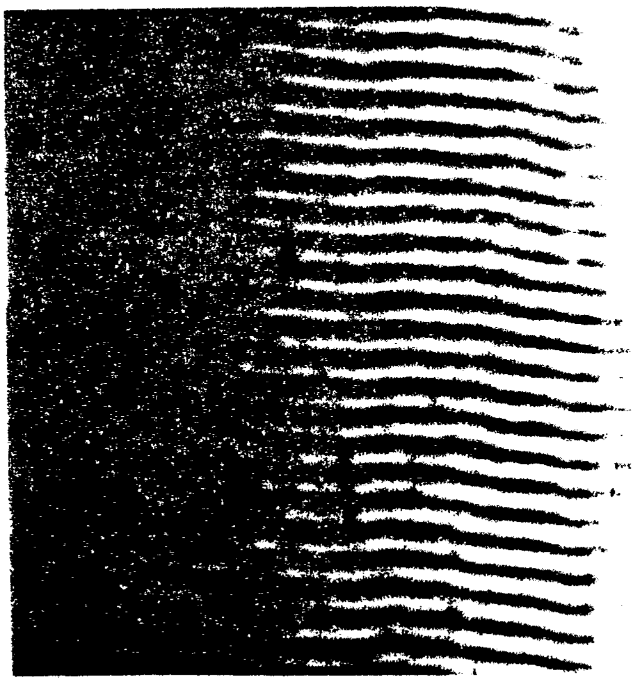

FIG. 11